# EUROPEAN PATENT SPECIFICATION

(11) **EP 1 218 557 B1**
(45) Date of publication and mention of the grant of the patent: **16.06.2004**
(21) Application number: 00959092.8
(22) Date of filing: 31.08.2000
(51) Int. Cl.: C22C 29/08, C23C 16/30, C23C 16/40, C22C 28/00, B23B 27/14

(54) **COATED GROOVING OR PARTING INSERT**
BESCHICHTETER NUT- ODER ABSTECHEINSATZ
INSERT DE COUPE ET DE RAINURAGE A REVETEMENT

(30) Priority: 01.09.1999 SE 9903089
(43) Date of publication of application: 03.07.2002
(73) Proprietor: Sandvik AB (publ), 811 81 Sandviken (SE)
(72) Inventor: JONSSON, Anders, S-804 27 Gävle (SE); Piirhonen, Anders, S-128 34 Skarpnäck (SE); SELINDER, Torbjörn, S-117 61 Stockholm (SE); KULLANDER, Gregor, S-125 51 Älvsjö (SE)
(74) Representative: Taquist, Lennart
(86) International application number: PCT/SE2000/001677
(87) International publication number: WO 2001/016388

(56) References cited:
- EP-A1- 0 701 982
- EP-A2- 1 038 989
- WO-A1-97/20083
- DATABASE WPI Week 199944, Derwent Publications Ltd., London, GB; AN 1999-520900, XP002909844 & JP 11 222 665 A (NACHI FUJIKOSHI CORP) 17 August 1999

## Description

The present invention relates to a coated cutting tool (cemented carbide insert) useful for grooving or particularly parting of steel components such as bars or tubes of stainless steels of different composition and microstructure but also for of non-stainless steels such as low carbon steels and low and medium alloyed steels.

When machining low and medium alloyed steels and stainless steels with cemented carbide tools the cutting edge is worn according to different wear mechanisms, such as chemical wear, abrasive wear, adhesive wear and by edge chipping. In bad conditions problems with bulk and edge line breakages occur commonly. Furthermore, different cutting conditions such as cutting speed, cutting feed rate and also external conditions such as dry or wet machining, heavy vibrations of the work piece etc., require a plurality of different properties of the cutting edge.

So far it has been very difficult to improve all tool properties simultaneously. Commercial cemented carbide grades have therefore been optimized with respect to one or few of these wear types and hence to specific application areas.

WO 97/20083 discloses a coated cutting insert particularly useful for dry and wet machining in low and medium alloyed steels, stainless steels, with or without raw surface zones under severe conditions such as vibrations, long overhang and recutting of chips. The insert is characterized by WC-Co cemented carbide with a low content of cubic carbides and a rather low W-alloyed binder phase and a coating including an innermost layer of TiCₓN_{y}O_{z} with columnar grains and a top layer of TiN and an inner layer of κ-Al₂O₃.

Swedish patent application SE 9901149-6 (EP-A-1038989) discloses a coated cutting insert particularly useful at high cutting speeds, of stainless steels of different composition and microstructure, but also for the milling of non-stainless steels such as low carbon steels and low and medium alloyed steels. The coated WC-Co based cemented carbide insert is characterized by a specific composition range of WC/Co without any addition of cubic carbides, by a low W-alloyed Co binder and by a narrow range defined average WC grainsize, and a hard and wear resistant coating including a multilayered structure of sublayers of the composition (TiₓAl₁₋ₓ)N with repeated variation of the Ti/Al ratio.

Multilayer surface coating for cutting tools having layers of various TiₓAl₁₋ₓN compositions and structures are known in general from EP-A-701 982.

It has now surprisingly been found that a combination of a slightly modified cemented carbide substrate described in the above mentioned WO 97/20083 and the coating described in the above mentioned SE 9901149-6 results excellent cutting performance in grooving or, in particular, parting of steel or stainless steel.

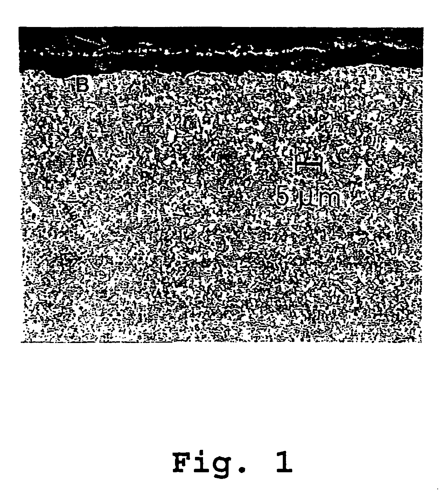

In Fig. 1 is shown a micrograph in 1200X magnificatio of a polished cross section of a coated insert according to the present invention:
A - cemented carbide body
B - innermost TiN layer
C - layer of several TiAlN sublayers
D - layer of TiAlN
E - outermost TiN layer

According to the present invention as defined in claim 1, there is provided a coated cutting tool insert for toughness demanding grooving and parting of stainless steels comprising a WC-Co based cemented carbide body with a composition of 12.0-13.0 wt% Co, preferably 12.3-12.9 wt% Co, 0.4-1.8 wt% cubic carbides, preferably 0.5-1.7 wt% cubic carbides of the metals Ta, Nb and balance WC. The content of Ti is preferably on a level corresponding to a technical impurity. The average grain size of the WC is about 1.4 µm.

The cobalt binder phase is rather low alloyed with W. The content of W in the binder phase can be expressed as the CW-ratio:${\text{CW-ratio= M}}_{\text{s}} \text{/ (wt% Co · 0.0161),}$ where Mₛ is the saturation magnetization of the cemented carbide body in kA/m and wt% Co is the weight percentage of Co in the cemented carbide. The CW-value is a function of the W content in the Co binder phase. A high CW-value corresponds to a low W-content in the binder phase.

It has now been found according to the present invention that improved cutting performance is achieved if the cemented carbide body has a CW-ratio of 0.82-0.91, and most preferably 0.85-0.90. The cemented carbide may contain small amounts, <1 volume %, of η -phase (M₆C), without any detrimental effect. From the CW-value it follows that no free graphite is allowed in the cemented carbide body according to the present invention.

The hard and wear resistant refractory coating deposited on the cemented carbide substrate according to the present invention comprises:
- a first (innermost) thin 0.1-0.5 µm bonding layer of TiN
- a second layer comprising a multilayered structure of sublayers of the composition (TiₓAl₁₋ₓ)N in which x varies repeatedly between the two ranges 0.45<x<0.55 and 0.70<x<0.80. The first sublayer of (TiₓAl₁₋ₓ)N adjacent to the TiN bonding layer having an x-value of 0.45<x<0.55, the second sublayer of (TiₓAl₁₋ₓ)N having an x-value of 0.70<x<0.80 and the third sublayer having x of 0.45<x<0.55 and so forth repeated until 12-25 sublayers, preferably 22-24 sublayers, are being built up. The thickness of this second layer comprising a multilayered structure of sublayers constitutes 75-95% of the total coating thickness. The individual sublayers of (TiₓAl₁₋ₓ)N are essentially of the same thickness but their thickness may also vary in a regular or irregular way and said sublayer thickness is 0.05-0.2 µm each.
- a third 0.1-0.5 µm layer of (TiₓAl₁₋ₓ)N having an x-value of 0.45<x<0.55.
- a fourth (outermost) thin 0.1-0.2 µm layer of TiN.

The total thickness of the coating is 1-8 µm, preferably 2-5 µm. The layer thickness, the sublayer thickness and the coating thickness quoted above refers to measurements made close to the cutting edge, i. e. the functional part of the cutting tool.

The present invention also relates to a method (defined in claim 4) of making a coated cutting tool insert consisting of a cemented carbide body with a composition of 12.0-13.0 wt% Co, most preferably 12.3-12.9 wt% Co, 0.4-1.8 wt% cubic carbides, preferably 0.5-1.7 wt% cubic carbides of the metals Ta, Nb and balance WC. The content of Ti is preferably on a level corresponding to a technical impurity. The average grain size of the WC is about 1.4 µm.

The hard and wear resistant refractory coating is deposited onto the cemented carbide substrate by applying conventional PVD (Physical Vapor Deposition) or CVD (Chemical Vapor Deposition) methods and according to the present invention said coating comprises:
- a first (innermost) thin 0.1-0.5 µm bonding layer of TiN
- a second layer comprising a multilayered structure of sublayers of the composition (TiₓAl₁₋ₓ)N in which x varies repeatedly between the two ranges 0.45<x<0.55 and 0.70<x<0.80. The first sublayer of (TiₓAl₁₋ₓ)N adjacent to the TiN bonding layer having an x-value of 0.45<x<0.55, the second sublayer of (TiₓAl₁₋ₓ)N having an x-value of 0.70<x<0.80 and the third sublayer having x of 0.45<x<0.55 and so forth repeated until 12-25 sublayers, preferably 22-24 sublayers, are being built up. The thickness of this second layer comprising a multilayered structure of sublayers constitutes 75-95% of the total coating thickness. The individual sublayers of (TiₓAl₁₋ₓ)N are essentially of the same thickness but their thickness may also vary in a regular or irregular way and said sublayer thickness is 0.05-0.2 µm.
- a third thin 0.1-0.5 µm layer of (TiₓAl₁₋ₓ)N having an x-value of 0.45<x<0.55.
- a fourth (outermost) 0.1-0.2 µm layer of TiN.

### Example 1

A. Cemented carbide parting tool insert in accordance with the invention with the composition 12.6 wt-% Co, 1.25 wt-% TaC, 0.30 wt-% NbC and balance WC with 1.4 µm grain size and with a binder phase alloyed with W corresponding to a CW-ratio of 0.91 were coated with a 4 µm thick coating by applying conventional PVD cathodic arc technique. The coating consisted of a first (innermost) 0.2 µm layer of TiN followed by a 3.2 µm thick second layer comprising 23 alternating sublayers of (TiₓAl₁₋ₓ)N, where x alternatively varied between 0.55 and 0.75, and a third 0.2 µm (TiₓAl₁₋ₓ)N, where x= 0.55, and, finally, an outermost 0.4 µm layer of TiN.
B. A cemented carbide parting tool insert with the composition of 8.0 wt-% Co, no cubic carbides, balance WC and a CW-ratio of 0.94. The insert was coated with an innermost 0.5 µm equiaxed TiCN-layer A 1.5 µm TiN layer was deposited, during the same cycle, on top of the TiCN-layer. No post treatment was applied.
C. A competitive cemented carbide parting tool insert in style similar to previous mention inserts from an external leading cemented carbide producer was selected for comparison. The cemented carbide had a composition of 12.5 wt-% Co, 0.1 wt-% TiC, 1.8 wt-% TaC, 0.2 wt-% NbC, balance WC and a CW-ratio of 0.87. The insert had a coating consisting of 1.4 µm TiN and, outermost, 1.4 µm TiCN. Examination in light optical microscope revealed no edge treatment subsequent to coating.

Inserts A, B and C from above were tested in a parting off to centre in stainless steel SS2321 with OD 26 mm. The cutting speed was varied from 86 to 0 m/min with feed 0,05 mm/r. The wear mechanism was uneven flank wear and chipping.

| Insert | Number of components |
|---|---|
| A (invention) | 50 |
| B (outside invention) | 13 |
| C (external grade) | 41 |

### Example 2

Insert A and B were tested at an end user's machine shop in a parting of a stainless steel component (AISI 316 OD 42 mm) with cutting speed varying from 110 to 0 m/min and with feed varying 0,08-0,03 mm/r (low feed rate close to centre of bar). The wear mechanism was fracture in cutting zone.

| Insert | Number of components |
|---|---|
| A (invention) | 201 |
| B (outside invention) | 224 |

### Example 3

Insert A and B were tested at an end users machine shop in a parting of a steel component (SS2172 OD 47 mm) with rotating speed 1800 rpm and with feed 0,1 mm/r. The wear mechanism was flank wear and flaking.

| Insert | Number of components |
|---|---|
| A (invention) | 163 |
| B (outside invention) | 50 |

### Example 4

Insert A and C were tested at an end user's machine shop in a parting of a stainless steel component (AISI 316 OD 31 mm) with cutting speed varying from 60 to 0 m/min and with feed varying 0,06-0,03 mm/r (low feed rate close to the centre of the bar). The wear mechanism was flank wear and chipping.

| Insert | Number of components |
|---|---|
| A (invention) | 182 |
| C (external grade) | 43 |

## Claims

1. A cutting tool insert particularly for parting of steel and stainless steel comprising a cemented carbide body and a coating **characterised in that** said cemented carbide body consists of WC with an average grain size of about 1.4 µm, 12-13 wt-% Co alloyed with W as binder, 0.4-1.8 wt-% TaC+NbC, and the low W-alloyed binder phase has a CW-ratio of 0.82-0.91 whereby CW-ratio = Mₛ/(wt% Co x 0,0161), Mₛ is the saturation magnetization of the cemented carbide body in kA/m and **in that** said coating comprises
- a first (innermost) 0.1-0.5 µm layer of TiN
- a second layer comprising a multilayered structure of each 0.05-0.2 µm thick sublayers of the composition (TiₓAl₁₋ₓ)N in which x varies repeatedly between the two ranges 0.45<x<0.55 and 0.70<x<0.80, the first sublayer of (TiₓAl₁₋ₓ)N adjacent to the TiN bonding layer having an x-value of 0.45<x<0.55, the second sublayer of (TiₓAl₁₋ₓ)N having an x-value of 0.70<x<0.80 and the third sublayer having x of 0.45<x<0.55 and so forth repeated until 12-25 sublayers are being built up.
- a third 0.1-0.5 µm thick layer of (TiₓAl₁₋ₓ)N, where x is 0.45<x<0.55
- a fourth (outermost) 0.1-0.2 µm layer of TiN where the total coating thickness is 1-8 µm and
where the thickness of the second layer constitutes 75-95% of the total coating thickness.

2. Cutting insert according to claim 1 **characterized in that** the cemented carbide has the composition 12.3-12.9 wt-% Co and 0.5-1.7 wt% TaC+NbC.

3. Cutting insert according to any of the preceding claims **characterized in that** the cemented carbide body is free from graphite.

4. Method based on known PVD or CVD techniques of making a coated cemented carbide cutting tool insert comprising a WC-Co based cemented carbide body and a hard and wear resistant coating,
**characterized in** depositing on a cemented carbide body comprising a WC with an average grain size of about 1.4 µm, 12-13 wt-% Co alloyed with W as binder, 0.4-1.8 wt-% TaC+NbC, and the low W-alloyed binder phase has a CW-ratio of 0.82-0.91 whereby CW-ratio = Mₛ/(wt% Co x 0,0161), Mₛ is the saturation magnetization of the cemented carbide body in kA/m, a coating comprising
- a first (innermost) 0.1-0.5 µm layer of TiN
- a second layer comprising a multilayered structure of each 0.05-0.2 µm thick sublayers of the composition (TiₓAl₁₋ₓ)N in which x varies repeatedly between the two ranges 0.45<x<0.55 and 0.70<x<0.80, the first sublayer of (TiₓAl₁₋ₓ)N adjacent to the TiN bonding layer having an x-value of 0.45<x<0.55, the second sublayer of (TiₓAl₁₋ₓ)N having an x-value of 0.70<x<0.80 and the third sublayer having x in the range 0.45<x<0.55 and so forth repeated until 12-25 sublayers are being built up.
- a third 0.1-0.5 µm thick layer of (TiₓAl₁₋ₓ)N, where x is 0.45<x<0.55
- a fourth (outermost) 0.1-0.2 µm layer of TiN making the total coating thickness close to the cutting edge vary in the range of 1-8 µm and where the thickness of the second layer constitutes 75-95% of the total coating thickness.

5. Method according to the previous claim **characterized in that** said cemented carbide body comprises a WC-Co composition of WC with an average grain size of about 1.4 µm, 12-13 wt-% Co and 0.4-1.8 wt-% TaC+NbC, and the said low W-alloyed binder phase with a CW-ratio of 0.82-0.91.

## Patentansprüche

1. Schneidwerkzeugeinsatz, insbesondere zum Teilen von Stahl und rostfreiem Stahl mit einem Hartmetallkörper und einer Beschichtung, **dadurch gekennzeichnet, daß** der Hartmetallkörper aus WC mit einer mittleren Korngröße von etwa 1,4 µm, 12-13 Gew.-% Co, mit W legiert, als Bindemittel, 0,4-1,8 Gew.-% TaC+NbC besteht und die mit W niedriglegierte Bindephase ein CW-Verhältnis von 0,82-0,91 hat, wobei das CW-Verhältnis = Mₛ/(Gew.-% Co x 0,0161), worin Mₛ die Sättigungsmagnetisierung des Hartmetallkörpers in kA/µ ist, und daß jene Beschichtung
- eine erste (innerste) 0,1-0,5 µm dicke TiN-Schicht,
- eine zweite Schicht, die eine vielschichtige Struktur von jeweils 0,05-0,2 µm dicken Unterschichten der Zusammensetzung (TiₓAl₁₋ₓ)N umfaßt, worin x wiederholt zwischen den beiden Bereichen 0,45<x<0,55 und 0,70<x<0,80 variiert, die erste Unterschicht von (TiₓAl₁₋ₓ)N in Nachbarschaft zu der TiN-Bindungsschicht mit einem x-Wert von 0,45<x<0,55, die zweite Unterschicht von (TiₓAl₁₋ₓ)N einen x-Wert von 0,70<x<0,80 hat und die dritte Unterschicht ein x von 0,45<x<0,55 ist, usw. wiederholt, bis 12-25 Unterschichten aufgebaut sind,
- eine dritte 0,1-0,5 µm dicke Schicht von (TiₓAl₁₋ₓ)N, worin x 0,45<x<0,55 ist, und
- eine vierte (äußerste) Schicht von 0,1-0,2 µm TiN umfaßt, wobei die gesamte Beschichtungsdicke 1-8 µm ist und die Dicke der zweiten Schicht 75-95 % der gesamten Beschichtungsdicke beträgt.

2. Schneideinsatz nach Anspruch 1, **dadurch gekennzeichnet, daß** das Hartmetall die Zusammensetzung 12,3-12,9 Gew.-% Co und 0,5-1,7 Gew.-% TaC+NbC hat.

3. Schneideinsatz nach einem der vorausgehenden Ansprüche, **dadurch gekennzeichnet, daß** der Hartmetallkörper frei von Graphit ist.

4. Verfahren auf der Basis bekannter PVD- oder CVD-Techniken zur Herstellung eines beschichteten Hartmetallschneidwerkzeugeinsatzes, der einen Hartmetallkörper auf WC-Co-Basis und eine harte und verschleißbeständige Beschichtung umfaßt, **dadurch gekennzeichnet, daß** man auf einem Hartmetallkörper, der WC mit einer mittleren Korngröße von etwa 1,4 µm, 12-13 Gew.-% mit W legiertes Co als Bindemittel umfaßt und die mit W niedriglegierte Bindephase ein CW-Verhältnis von 0,82-0,91 hat, wobei das CW-Verhältnis = Mₛ/(Gew.-% Co x 0,0161), wobei Mₛ/(Gew.-% Co x 0,0161) und Mₛ die Sättigungsmagnetisierung des Hartmetallkörpers in kA/µ ist, eine Beschichtung abscheidet, die
- eine erste (innerste) 0,1-0,5 µm Dicke TiN-Schicht,
- eine zweite Schicht, die eine vielschichtige Struktur von jeweils 0,5-0,2 µm dicken Unterschichten der Zusammensetzung (TiₓAl₁₋ₓ)N umfaßt, worin x wiederholt zwischen den beiden Bereichen 0,45<x<0,55 und 0,70<x<0,80 variiert, die erste Unterschicht von (TiₓAl₁₋ₓ)N in Nachbarschaft zu der TiN-Bindungsschicht mit einem x-Wert von 0,45<x<0,55, die zweite Unterschicht von (TiₓAl₁₋ₓ)N einen x-Wert von 0,70<x<0,80 hat und die dritte Unterschicht ein x von 0,45<x<0,55 ist, usw. wiederholt, bis 12-25 Unterschichten aufgebaut sind,
- eine dritte 0,1-0,5 µm dicke Schicht von (TiₓAl₁₋ₓ)N, worin x 0,45<x<0,55 ist, und
- eine vierte (äußerste) 0,1-0,2 µm dicke Schicht von TiN umfaßt,
die Gesamtbeschichtungsdicke nahe der Schneidkante im Bereich von 1-8 µm variieren läßt, wobei die Dicke der zweiten Schicht 75-95 % der gesamten Beschichtungsdicke beträgt.

5. Verfahren nach einem der vorausgehenden Ansprüche, **dadurch gekennzeichnet, daß** der Hartmetallkörper eine WC-Co-Zusammensetzung von WC mit einer mittleren Korngröße von etwa 1,4 µm, 12-13 Gew.-% Co und 0,4-1,8 Gew.-% TaC+NbC umfaßt und die mit W niedriglegierte Bindephase ein CW-Verhältnis von 0,82-0,91 hat.

## Revendications

1. Plaquette d'outil de coupe particulièrement destinée à la séparation d'acier et d'acier inoxydable comprenant un corps de carbure cémenté et un revêtement **caractérisé en ce que** ledit corps de carbure cémenté est constitué de WC avec une granulométrie moyenne d'environ 1,4 µm, 12 à 13 % en poids de Co allié avec W en tant que liant, 0,4 à 1,8 % en poids de TaC + NbC, et la phase de liant alliée à faible teneur en W présente un rapport de CW de 0,82 à 0,91 grâce à quoi le rapport de CW = Mₛ/( % en poids de Co x 0,0 161), Mₛ est la magnétisation de saturation du corps de carbure cémenté en kA/m et **en ce que** ledit revêtement comprend
- une première couche (la plus à l'intérieur) de 0,1 à 0,5 µm de TiN
- une seconde couche comprenant une structure multicouche de sous-couches chacune d'une épaisseur de 0,05 à 0,2 µm de composition (TiₓAl₁₋ₓ)N dans laquelle x varie de façon répétitive entre les deux plages 0,45 < x < 0,55 et 0,70 < x < 0,80, la première sous-couche de (TiₓAl₁₋ₓ)N adjacente à la couche de liaison de TiN présentant une valeur x de 0,45 < x < 0,55, la seconde sous-couche de (TiₓAl₁₋ₓ)N présentant une valeur de x de 0,70 < x < 0,80 et la troisième sous-couche présentant une valeur de x de 0,45 < x < 0,55 et en répétant ainsi de suite jusqu'à ce que 12 à 25 sous-couches soient accumulées.
- une troisième couche d'une épaisseur de 0,1 à 0,5 µm de (TiₓAl₁₋ₓ)N, où x est tel que 0,45 < x < 0,55
- une quatrième couche (la plus à l'extérieur) de 0,1 à 0,2 µm de TiN
où l'épaisseur de revêtement totale est de 1 à 8 pm et où l'épaisseur de la seconde couche constitue 75 à 95 % de l'épaisseur totale du revêtement.

2. Plaquette de coupe selon la revendication 1 **caractérisée en ce que** le carbure cémenté présente la composition de 12,3 à 12,9 % en poids de Co et 0,5 à 1,7 % en poids de TaC + NbC.

3. Plaquette de coupe selon l'une quelconque des revendications précédentes, **caractérisée en ce que** le corps de carbure cémenté est dépourvu de graphite.

4. Procédé fondé sur des techniques de dépôt physique en phase vapeur ou chimique en phase vapeur connues pour réaliser une plaquette d'outil de coupe en carbure cémenté enduite comprenant un corps de carbure cémenté à base WC-Co et un revêtement dur et résistant à l'usure,
**caractérisé par** un dépôt sur un corps de carbure cémenté comprenant WC avec une granulométrie moyenne d'environ 1,4 µm, de 12 à 13 % en poids de Co allié avec W en tant que liant, 0,4 à 1,8 % en poids de Tac + NbC, et la phase de liant alliée à faible teneur en W présente un rapport de CW de 0,82 à 0,91 d'où il résulte que le rapport de CW = Mₛ/( % en poids de Co x 0,0 161), Mₛ est la magnétisation de saturation du corps de carbure cémenté en kA/m, un revêtement comprenant
- une première couche (la plus à l'intérieur) de 0,1 à 0,5 µm de TiN
- une seconde couche comprenant une structure multicouche de sous-couches chacune d'une épaisseur de 0,05 à 0,2 µm de composition (TiₓAl₁₋ₓ)N dans laquelle x varie de façon répétitive entre les deux plages 0,45 < x < 0,55 et 0,70 < x < 0,80, la première sous-couche de (TiₓAl₁₋ₓ)N adjacente à la couche de liaison de TiN présentant une valeur x de 0,45 < x < 0,55, la seconde sous-couche de (TiₓAl₁₋ₓ)N présentant une valeur de x de 0,70 < x < 0,80 et la troisième sous-couche présentant une valeur de x dans la plage de 0,45 < x < 0,55 et en répétant ainsi de suite jusqu'à ce que 12 à 25 sous-couches soient accumulées.
- une troisième couche d'une épaisseur de 0,1 à 0,5 µm de (TiₓAl₁₋ₓ)N, où x est tel que 0,45 < x < 0,55
- une quatrième couche (la plus à l'extérieur) de 0,1 à 0,2 µm de TiN
ce qui amène l'épaisseur totale du revêtement près de l'arête de coupe à varier dans la plage de 1 à 8 µm et où l'épaisseur de la seconde couche constitue 75 à 95 % de l'épaisseur totale du revêtement.

5. Procédé selon la revendication précédente, **caractérisé en ce que** ledit corps de carbure cémenté comprend une composition de WC-Co dont le WC présente une granulométrie moyenne d'environ 1,4 µm, 12 à 13 % en poids de Co et 0,4 à 1,8 % en poids de TaC + NbC, et ladite phase de liant alliée en faible teneur en W avec un rapport de CW de 0,82 à 0,91.
